# EUROPÄISCHE PATENTSCHRIFT

(11) **EP 1 021 843 B1**
(45) Veröffentlichungstag und Bekanntmachung des Hinweises auf die Patenterteilung: **25.06.2003**
(21) Anmeldenummer: 99941409.7
(22) Anmeldetag: 29.06.1999
(51) Int. Cl.: H01L 41/08

(54) **ELEKTROMECHANISCHER WANDLER UND VERFAHREN ZUR HERSTELLUNG**
ELECTROMECHANICAL CONVERTER AND METHOD FOR PRODUCING THE SAME
TRANSDUCTEUR ELECTROMECANIQUE ET SON PROCEDE DE PRODUCTION

(30) Priorität: 30.06.1998 DE 19829216
(43) Veröffentlichungstag der Anmeldung: 26.07.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: SPORN, Dieter, D-97082 Würzburg (DE); WATZKA, Winfried, D-97072 Würzburg (DE); SCHÖNECKER, Andreas, D-01705 Freital (DE); SEFFNER, Lutz, D-01109 Dresden (DE); PANNKOKE, Kord, D-28203 Bremen (DE)
(74) Vertreter: Gagel, Roland, Dr.
(86) Internationale Anmeldenummer: DE9901895
(87) Internationale Veröffentlichungsnummer: WO00002265

(56) Entgegenhaltungen:
- US-A- 4 984 222

## Beschreibung

Die Erfindung betrifft einen elektromechanischen Wandler, Verfahren zur Herstellung desselben sowie ein Verbundsystem, das den elektromechanischen Wandler enthält.

Ein bevorzugtes Anwendungsgebiet der Erfindung ist der Bereich adaptiver Werkstoffe. Aktive Werkstoffe können sich ändernden Umgebungsbedingungen reversibel und definiert anpassen, wenn sie über eine adaptive Schaltung gesteuert werden. Sie ermöglichen beispielsweise Schwingungsdämpfung, Schallreduktion und Kontursteuerung von Bauteilen. Hierbei besteht ein besonderer Bedarf an mechanisch belastbaren Verbundwerkstoffen, die sensorische und aktorische Komponenten enthalten.

Elektromechanische Wandler, deren Funktionsweise auf dem piezoelektrischen Effekt beruht, eignen sich in besonderer Weise für die Einbindung bzw. Integration in derartige Verbundwerkstoffe. Diese Wandler arbeiten als empfindlicher Kraft- bzw. Wegsensor und zeigen als Aktor ein herausragendes Potential für Kraft- bzw. Weggenerierung bei hoher Dynamik.

Idealerweise sollte der elektromechanische Wandler hierbei so in die Gesamtstruktur eines Verbundwerkstoffes integrierbar sein, daß die mechanischen Eigenschaften dieser Struktur möglichst wenig beeinträchtigt werden. Weiterhin sollte der Wandler mit einer möglichst niedrigen elektrischen Spannung angesteuert werden können.

Das Ziel dieser strukturkonformen Integration, d.h. der minimalen Störung der Gesamtstruktur, kann gerade durch den Einsatz von faserförmigen Piezoelektrika, insbesondere ferroelektrischer Keramiken, erreicht werden.

In R.E. Newnham, D.P. Skinner, L.E. Cross, Mat. Res. Bull., 13 (1978) 525, wird die Konzeptionierung und Herstellung von Verbundwerkstoffen bzw. Komposita aus funktionellen Keramiken und einer Polymermatrix beschrieben. Es werden u.a. die Vorteile von Komposita, die Fasern bzw. Stäbchen aus ferroelektrischer Keramik enthalten, berechnet und verifiziert (siehe z.B. R.E. Newnham, A. Safari, J. Giniewicz, B.H. Fox, Ferroelectrics, 60 (1984) 15 - 21). Bei diesen Arbeiten bestehen die Komposita aus dünnen Scheibchen von ca. 1 mm Dicke, in denen die Fasern senkrecht zur Stirnseite angeordnet sind. Die Fasern werden hierbei durch Elektrodieren der Stirnseiten polarisiert und angesteuert.

Ferroelektrika benötigen für ihre Polung, die zum Erreichen der piezoelektrischen Eigenschaften notwendig ist, elektrische Felder einer bestimmten Größe. Die Polung erfolgt zwischen zwei Elektroden mit dem Abstand d und mit einer elektrischen Spannung U. Das resultierende elektrische Feld E = U/d nimmt mit zunehmendem Abstand d der Elektroden ab. Daher können längere Fasern nicht durch Elektrodieren ihrer Enden polarisiert werden, da die benötigten Polungsfelder von bis zu 6 kV/mm bereits ab Faserlängen von einigen mm in der Praxis nicht erzielt werden können. Die Polarisierung langer Fasern, d.h. von einem oder mehreren cm Länge, in Längsrichtung ist daher in einem herkömmlichen diskontinuierlichen Polungsschritt mit zwei Elektroden an den Stirnseiten nicht möglich, da die benötigten elektrischen Felder Spannungen von über 100 kV erfordern würden.

In A.A. Bent, "Active Fiber Composites for Structural Actuation", Ph.D. Thesis, MIT, Januar 1997, ist eine Technik beschrieben, mit der längere Fasern in Längsrichtung polarisiert werden können. Hierzu werden in gewissen Abständen entlang der Längsachse der Fasern Elektroden angelegt, um die Fasern abschnittsweise anzusteuern. Die Elektroden werden abwechselnd positiv und negativ verschaltet. Somit können die in den Fasern zur Polung benötigten elektrischen Felder durch weitaus geringere elektrische Spannungen erreicht werden, als wenn die Fasern über die Stirnseiten als Ganzes der Länge nach gepolt und angesteuert werden müßten. Zur Herstellung dieses Systems werden die Elektroden zunächst in strukturierter Form auf Kapton-Schichten aufgebracht. Dies erfolgt durch Aufbringen einer Silbertinte mittels der Technik des sog. Screen-Printings. Die Fasern werden zwischen diesen Kapton-Schichten angeordnet, die die haftende Verbindung zu den Fasern herstellen. Somit liegt bei dem fertigen Wandler eine Anordnung vor, bei der die Fasern zwischen zwei Kapton-Schichten eingebettet sind, auf denen jeweils eine ebene Elektrodenstruktur vorliegt.

Eine derartige Anordnung hat jedoch den Nachteil, daß trotz der realisierbaren geringen Abstände zwischen den einzelnen Elektroden noch immer relativ hohe Spannungen benötigt werden, um die einzelnen Faserbereiche zu polarisieren.

Aufgabe der vorliegenden Erfindung ist es daher, einen elektromechanischen Wandler sowie Verfahren zur Herstellung desselben bereitzustellen, der für die Integration in ein Verbundsystem geeignet ist und die Polung und Ansteuerung mit niedrigeren elektrischen Spannungen ermöglicht.

Diese Aufgabe wird mit dem elektromechanischen Wandler nach Anspruch 1 sowie den Verfahren nach Anspruch 13 und 14 erreicht. Vorteilhafte Ausgestaltungen der Erfindung sind Gegenstand der Unteransprüche.

Der erfindungsgemäße elektromechanische Wandler besteht aus zumindest einer langgestreckten Faser bzw. einem dünnen Stäbchen aus einem piezoelektrischen Material. An voneinander beabstandeten Stellen der Faser sind zumindest zwei Elektroden vorgesehen, um die Faser mit einem elektrischen Feld zu beaufschlagen. Die Elektroden stehen hierbei mit der Faser in direktem Kontakt und umschließen die Faser zumindest teilweise. Unter direktem Kontakt ist hierbei auch zu verstehen, daß zwischen der Elektrode und der Faser keine weitere, beispielsweise dielektrische Schicht liegt.

Durch diesen direkten Kontakt zwischen Elektrode und Faser wird die optimale Einkopplung des elektrischen Feldes in die Faser ermöglicht, so daß niedrigere elektrische Spannungen an den Elektroden ausreichen, um die Faser zu polarisieren. Ein weiterer Vorteil des erfindungsgemäßen Aufbaus besteht darin, daß die Elektrode nicht nur an einem Punkt mit der Faser in direktem Kontakt steht, sondern über einen Teil des Umfangs der Faser. Hierdurch wird die Einkopplung des elektrischen Feldes weiter verbessert.

Vorzugsweise bestehen die Elektroden aus einem leitfähigen Klebstoff. Dieser läßt sich auf einfache Weise applizieren, haftet an der Faser, stabilisiert diese mechanisch und führt bei der Kontaktierung der Faser automatisch zu einem teilweisen Umschließen der Faser.

Eine weitere Verbesserung des elektromechanischen Wandlers wird dadurch erzielt, daß die einzelnen Elektroden die Faser vollständig umschließen. Die Elektroden bilden hierbei Ringelektroden um die Faser.

Der elektromechanische Wandler weist vorzugsweise Fasern mit einen Durchmesser von weniger als 100 µm und mit einer Länge von 5 bis 100 mm auf.

In einer bevorzugten Ausführungsform liegen dabei mehrere dieser Fasern parallel nebeneinander (Monolage) und werden von Elektroden in Interdigitalgeometrie kontaktiert, die quer zur Längsachse der Fasern verlaufen.

Ein wesentliches Merkmal des erfindungsgemäßen Wandlers besteht im direkten Kontakt des leitfähigen Materials mit der Faser. Hierdurch wird die erforderliche Spannung zur Erzeugung einer bestimmten Feldstärke in der Faser bereits deutlich verringert. Weiterhin ergibt sich durch das zumindest teilweise Umschließen der Faser (bei direktem Kontakt) eine weitere Verbesserung der Einkopplung der Feldstärke und damit eine Reduzierung der erforderlichen elektrischen Spannungen. Besonders vorteilhaft für die Herstellung ist die Verwendung eines leitfähigen Klebstoffs zur Bildung der Elektroden.

In einer bevorzugten Ausgestaltung der Erfindung werden lange ferroelektrische Fasern zur Bildung einer Monolage parallel nebeneinander angeordnet. Die Fasern werden dadurch gepolt und angesteuert, daß die Elektroden entlang ihrer Längsachse in kurzen Abständen aufgebracht werden, wie dies beispielsweise in A.A. Bent, "Active Fiber Composites for Structural Actuation", Ph.D. Thesis, MIT, Januar 1997, vorgeschlagen wird. Diese Elektroden werden abwechselnd positiv und negativ verschaltet. Somit können die in den Fasern zur Polung benötigten elektrischen Felder durch niedrige elektrische Spannungen erreicht werden.

Das erfindungsgemäße Konzept der Elektrodierung wird vorzugsweise durch parallele Bahnen aus leitfähigem Klebstoff verwirklicht, die senkrecht zur Ausrichtung der Monolage paralleler Fasern verlaufen. Für die Bereitstellung großer Wandlerflächen können mehrere erfindungsgemäß aufgebaute Wandler nebeneinander angeordnet werden.

Für die Integration des erfindungsgemäßen Wandlers mit den Piezofasern in ein Verbundwerkstoff-Laminat, werden ober- und unterhalb der aktiven Einzelschicht weitere Schichten des Verbundmaterials auflaminiert.

Mit einem solchen Verbundwerkstoff eröffnet sich eine Reihe von Anwendungsfeldern in den verschiedensten Industriezweigen. Die Schädigung von Verbundstrukturen kann unter Ausnutzung des direkten Piezoeffekts erfaßt werden, ohne daß durch die Sensoren, d.h. den bzw. die erfindungsgemäßen elektromechanischen Wandler, die Struktur des Verbundwerkstoffes gestört wird. Durch den inversen Piezoeffekt können die Wandler als aktive Komposita die Geometrie von Verbundwerkstoff-Bauteilen verändern. Eine mechanische Schwingung können die Komposita aktiv durch Erzeugen einer Gegenwelle oder passiv durch Kurzschließen der beim Piezoeffekt erzeugten Spannungen dämpfen.

Hierbei können weitere Verbesserungen durch die im folgenden beschriebenen Maßnahmen erreicht werden, die weitere Ausgestaltungen der Erfindung darstellen.

Durch Verringerung des Abstandes zwischen den Elektroden, d.h. den Kamm- bzw. Interdigitalelektroden, auf unter 100 µm werden die zum Polarisieren und Ansteuern der Fasern erforderlichen Spannungen weiter reduziert.

Für eine strukturkonforme Integration des elektromechanischen Wandlers weisen die funktionellen Fasern einen Durchmesser weit unter 100 µm, vorzugsweise < 30 µm auf. Nur bei derartigen Abmessungen stellen sie, in einen Faserverbundwerkstoff eingebracht, eine minimale strukturelle Störung dar und können ohne das Auftreten hoher mechanischer Momente gebogen werden.

Zur Erreichung der Strukturkonformität werden weiterhin die Fasern nur in einer sehr dünnen Kompositeinzelschicht, beispielsweise einer Polymerschicht, eingebettet, die dann wiederum in den Gesamtverbundwerkstoff integriert werden kann.

Mit den erfindungsgemäßen Verfahren können Kompositschichten dünner als 200 µm, ein Elektrodenabstand kleiner als 100 µm und eine parallele Faserablage von mehr als 100 Fasern pro cm nebeneinander erzielt werden. Bei der Verwendung von ferroelektrischen Keramikfasern als Funktionsfasern können diese polarisiert werden und anschließend als Drucksensor Kräfte kleiner als 1 N erfassen, durch ein elektrisches Wechselfeld zu Schwingungen angeregt werden und von außen eingebrachte mechanische Schwingungen aktiv (in Kombination mit einer adaptiven Schaltung) oder passiv dämpfen.

Als piezoelektrische Fasern bzw. Funktionsfasern werden dabei bevorzugt PZT-Fasern verwendet. Diese Fasern können durch Verfahren, wie beispielsweise in der DE 43 32 831 oder der DE 196 35 748 beschrieben, hergestellt werden.

Selbstverständlich ist der erfindungsgemäße elektromechanische Wandler nicht auf das bevorzugte Anwendungsgebiet der Verbundwerkstoffe begrenzt. So kann beispielsweise auch ein elektromechanischer Wandler mit einer einzelnen Faser als Aktor oder Sensor in der Mikrotechnik eingesetzt werden.

Die vorliegende Erfindung wird nachfolgend anhand der Ausführungsbeispiele in Verbindung mit den Zeichnungen näher erläutert. Hierbei zeigen
- Figur 1: schematisch ein Beispiel für einen erfindungsgemäßen Wandler;
- Figur 2a: ein Beispiel für die Elektrodierung eines Bereiches einer einzelnen Faser gemäß der Erfindung;
- Figur 2b: ein Beispiel für die Aufbringung einer weiteren Schicht auf die Faser der Figur 2a; und
- Figur 3: schematisch die Geometrie einer Elektrodenstruktur in einer Ausführungsform der Erfindung.

Ein Verfahren zur Herstellung von Verbundwerkstoffen, die den erfindungsgemäßen elektromechanischen Wandler mit ansteuerbaren piezoelektrischen Fasern, beispielsweise PZT-Fasern, enthalten, unterteilt sich in die Anfertigung und Aufbringung der Elektrodenstruktur, in die Herstellung der Fasergelege, in die Ablage der Fasern auf die Elektroden bzw. der Elektroden auf die Fasern, in das Eingießen und Laminieren dieses Strukturelements und das anschließende Polen der Fasern in der Struktur.

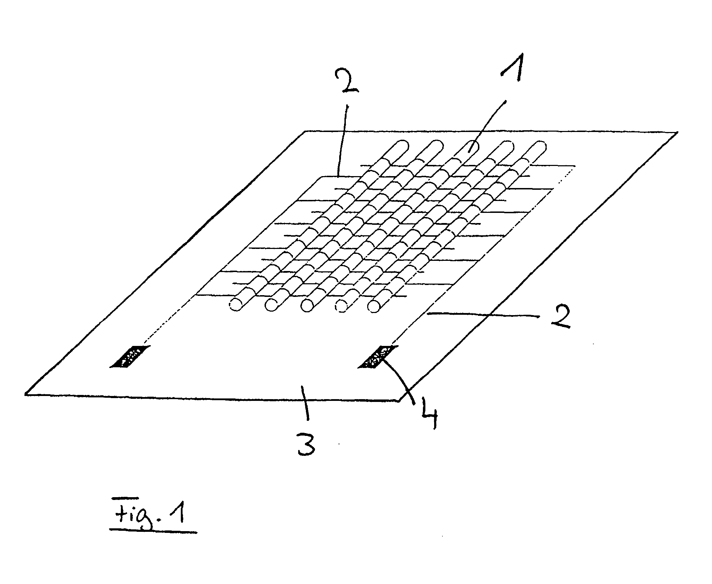

Figur 1 zeigt schematisch ein Beispiel für einen erfindungsgemäßen Wandler. In diesem Beispiel sind fünf Fasern (1) parallel nebeneinander auf einer Unterlage (3) angeordnet. Die Fasern werden entlang ihrer Längsachse an voneinander beabstandeten Stellen durch Elektroden kontaktiert, die in Interdigitalgeometrie angeordnet sind. Die Elektroden haben hierbei direkten Kontakt zu den Fasern und umschließen die einzelnen Fasern teilweise, wie aus der Figur deutlich zu erkennen ist. Der elektrische Anschluß der Anordnung erfolgt über die beiden Anschlußflächen (4) der Elektroden.

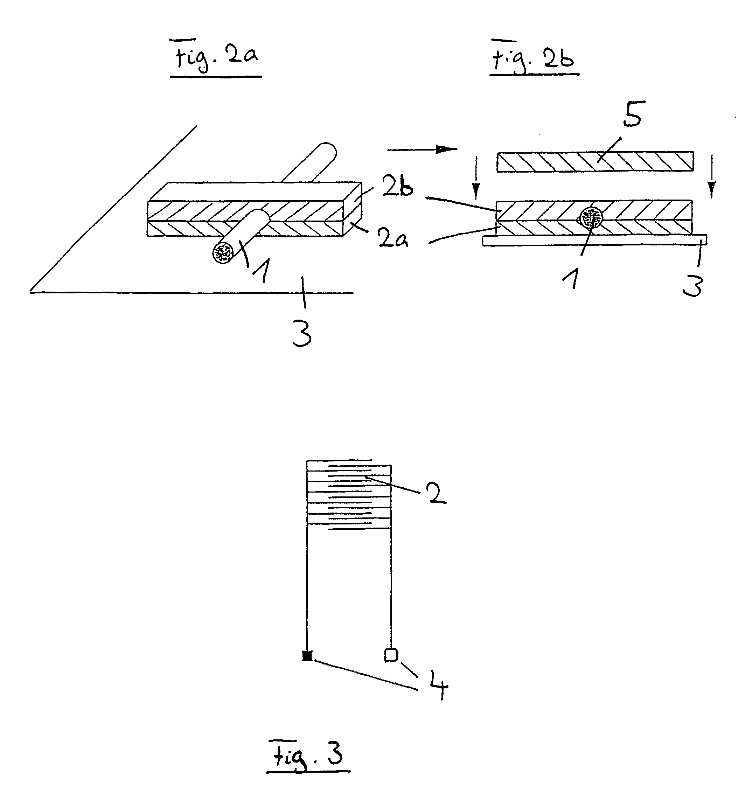

Figur 2a zeigt ein Beispiel für die Elektrodierung eines Bereiches einer einzelnen Faser (1). In diesem Beispiel besteht die Elektrodenstruktur (2) aus einer ersten Lage bzw. Schicht (2a) und einer darüberliegenden zweiten Lage (2b). Die zweite Lage ist hierbei optional vorgesehen. Während die Faser in die erste Lage teilweise eingebettet ist, so daß die Faser von der Elektrode zur Hälfte umschlossen wird, ermöglicht die zweite Lage das vollständige Umschließen der Faser. Auf diese Weise wird eine Ringelektrode gebildet, die die Faser umschließt.

Ein Beispiel für ein Verfahren zur Herstellung des erfindungsgemäßen elektromechanischen Wandlers wird im folgenden in Verbindung mit Figur 2 erläutert. Die Struktur der unteren Elektroden (2a), beispielsweise eine Interdigitalstruktur wie in Figur 3 gezeigt, wird in eine dünne Schablone als Negativform eingebracht. Durch einen Rakelschritt mit leitfähigem Klebstoff werden die Elektrodenbahnen (2) über die Negativform auf eine Unterlage (3) gerakelt. Die Unterlage kann beispielsweise aus einer Trägerschicht bestehen, oder aus dem Verbundwerkstoff selbst, in den der Wandler integriert werden soll.

Als leitfähiger Klebstoff wird bevorzugt ein thixotropes Epoxidharz, das Metallpartikeln (z.B. aus Ag) enthält, verwendet. Dieser Klebstoff läßt sich einerseits unter Druck leicht in die Negativschablone streichen und fließt andererseits bei Wegnahme der Schablone unter Beibehalten gerader Seitenflächen nicht weiter. Vor dem Aufbringen der Fasern (1) auf diese Struktur kann der Kleber so weit angehärtet werden, daß er auch unter Druck nicht fließt, jedoch noch die nötige Klebrigkeit dafür aufweist, daß Fasern an ihm haften. Das Anhärten wird durchgeführt, um ein Eindringen des Klebstoffes in Kapillaren zu verhindern, die sich zwischen den Fasern und der Unterlage im weiteren Verlauf ergeben können. Es erfolgt vorzugsweise bei erhöhten Temperaturen. Die Fasern (1) werden dann auf die Elektroden (2a) aufgebracht. Anschließend werden die Elektroden völlig ausgehärtet. Nun kann die Struktur vergossen werden, beispielsweise durch Aufbringen eines Harzes (5).

Eine Verbesserung der Eigenschaften des Wandlers wird erreicht, wenn vor dem Vergießen zusätzlich noch eine weitere Elektrodenschicht (2b) auf die Fasern (1) aufgebracht wird, die weitgehend deckungsgleich mit der ersten Elektrodenschicht (2a) ist. Diese Struktur wird mit Hilfe eines Dispensers, der leitfähigen Klebstoff verarbeiten kann, über die Fasern so regulär verteilt, daß diese an den Kreuzungspunkten der Elektrodenbahnen mit den Fasern jeweils vollständig von der Elektrode umgeben werden. Vorzugsweise wird in diesem Fall ein leitfähiger Klebstoff geringerer Viskosität als der für die untere Elektrodenschicht (2a) verwendet. Nach Aufbringen der Struktur wird auch dieser Klebstoff ausgehärtet. Anschließend kann diese Struktur ebenfalls, wie in Figur 2b gezeigt, mit einem Harz (5) vergossen werden.

Bei einem weiteren beispielhaften Verfahren zur Herstellung einer Ausgestaltungsform des erfindungsgemäßen Wandlers werden die Fasern zunächst in paralleler Anordnung in ein Polymer eingegossen. Nachfolgend wird mit einem Laser die Struktur für die Elektroden (2) in der Polymerschicht lokal abgetragen, bis die Faseroberfläche freiliegt. Die Wellenlänge und Energie des Lasers sind dabei so einzustellen, daß der Kunststoff entfernt wird, ohne die Fasern zu schädigen. Nach dem einseitigen Einbringen der Struktur wird die Elektrodenanordnung durch Füllen der Vertiefungen hergestellt. Dazu wird bevorzugt ein leitfähiger Klebstoff verwendet. Selbstverständlich sind auch andere Materialien möglich, beispielsweise durch Bedampfen der Fasern mit einem Metall. Sollen die Elektroden die Fasern jeweils vollständig umschließen, werden die Schritte Laserabtrag und Füllen für die gegenüberliegende Seite der Polymerschicht wiederholt.

Die vorzugsweise ferroelektrischen Fasern, die für einen flächigen Verbundwerkstoff verwendet werden, sind beispielsweise PZT-Fasern, wie sie in der DE 43 32 831 oder der DE 196 35 748 beschrieben sind. Diese werden über ein naßchemisches Verfahren, ein Sol-Gel-Verfahren, hergestellt und über thermische Schritte in keramische Fasern umgewandelt.

Die Fasern werden bevorzugt als Monolage elektrodiert, d.h. sie sind parallel angeordnet, ohne daß Fasern übereinander zu liegen kommen. Um dies zu erreichen, werden die Fasern entweder als Mono- oder als Multifilamentfaser (siehe DE 196 35 748) hergestellt und anschließend in eine Monolage gebracht, oder sie werden bereits als Monolage hergestellt.

Eine andere Möglichkeit, eine Monolage von PZT-Fasern zu erhalten, besteht darin, die Fasern bereits durch den Spinnvorgang, in dem sie noch als Sol-Gel-Stufe vorliegen, in ein Gelege paralleler Fasern zu bringen, die sich weitgehend nicht überdecken oder kreuzen. In den darauffolgenden Schritten Trocknung, Pyrolyse und Sinterung müssen die Fasern möglicherweise auf verschiedenen Unterlagen thermisch behandelt werden, was ein Umheben der Fasern nötig macht. Da die meisten funktionellen Fasern sehr fragil sind, sollte hierbei ein schonendes Verfahren eingesetzt werden, das die Fasern, ohne ihre parallele Anordnung zu stören, auf eine andere Unterlage hebt. Dies kann beispielsweise mittels einer Vakuumansaugtechnik erfolgen.

Das Aufbringen der Fasern auf die Elektrodenstruktur oder der Elektrodenstruktur auf die Fasern ist mit verschiedenen Methoden möglich.

So kann eine Trägerschicht mit den Elektroden aus noch nassem leitfähigen Klebstoff auf das Fasergelege abgesenkt werden. Durch einen gewissen Druck auf die Elektrodenstruktur werden die Fasern dann in den Klebstoff gedrückt.

Eine weitere Möglichkeit stellt das aufeinanderfolgende Aufbringen einzelner Fasern auf die Elektrodenstruktur dar. Dies kann manuell geschehen oder dadurch, daß die Fasern von oben durch einen Schlitz, der senkrecht zu den Elektrodenbahnen verläuft, auf diese herabfallen. Durch Bewegen des Schlitzes senkrecht zu den Elektrodenbahnen werden die Fasern hintereinander und parallel zueinander abgelegt.

Zur Integration in einen Verbundwerkstoff werden die einseitig oder ringsum elektrodierten Fasern vorzugsweise mit einem Polymer vergossen. Bevorzugt wird hierfür ein Epoxidharz verwendet, das dem des Matrixmaterials des Verbundwerkstoffs weitgehend gleicht.

Diese Schicht kann mit beliebig vielen weiteren Laminateinzelschichten, die wiederum PZT-Faserstrukturen enthalten können, überlaminiert werden.

Wurden die Fasern, wie bei dem zweiten oben beschriebenen Verfahren, nach Einbettung in ein Polymer elektrodiert, kann die Polymerschicht mit den Fasern direkt in den Verbundwerkstoff einlaminiert werden.

An den äußeren Anschlüssen (4), die beim Eingießen nicht mit Polymer bedeckt wurden, wird bei Einsatz des Wandlers durch eine Steuerelektronik bzw. Meßschaltung eine Spannung angelegt, durch die die Fasern, bevorzugt bei erhöhten Temperaturen, in der Struktur polarisiert werden. Über die Anschlüsse (4) werden die Fasern für ihre sensorischen oder aktorischen Aufgaben auch angesteuert.

Bei mehrfacher Anordnung des erfindungsgemäßen Wandlers innerhalb der Verbundstruktur, z.B. nebeneinander oder übereinander, können durch eine phasenverzögerte Ansteuerung der Wandler gezielt Schwingungen angeregt werden.

## Patentansprüche

1. Elektromechanischer Wandler mit zumindest einer langgestreckten Faser (1) aus einem piezoelektrischen Material und zumindest zwei Elektroden (2), die an voneinander beabstandeten Stellen der Faser vorgesehen sind, um die Faser mit einem elektrischen Feld in Längsrichtung zu beaufschlagen,
**dadurch gekennzeichnet,**
**daß** die Elektroden (2) mit der Faser (1) in direktem Kontakt stehen, wobei die einzelnen Elektroden die Faser zumindest teilweise umschließen.

2. Elektromechanischer Wandler nach Anspruch 1,
**dadurch gekennzeichnet,**
**daß** die Elektroden (2) aus einem elektrisch leitfähigen Klebstoff gebildet sind.

3. Elektromechanischer Wandler nach Anspruch 1 oder 2,
**dadurch gekennzeichnet,**
**daß** die einzelnen Elektroden (2) die Faser (1) vollständig umschließen.

4. Elektromechanischer Wandler nach einem der Ansprüche 1 bis 3,
**dadurch gekennzeichnet,**
**daß** die Faser (1) einen Durchmesser von weniger als 100 µm aufweist.

5. Elektromechanischer Wandler nach einem der Ansprüche 1 bis 4,
**dadurch gekennzeichnet,**
**daß** die Faser (1) eine Länge von 5 bis 100 mm aufweist.

6. Elektromechanischer Wandler nach einem der Ansprüche 1 bis 5,
**dadurch gekennzeichnet,**
**daß** entlang der Längsachse der Faser (1) mehrere Elektroden (2) in Interdigitalgeometrie angeordnet sind.

7. Elektromechanischer Wandler nach einem der Ansprüche 1 bis 6,
**dadurch gekennzeichnet,**
**daß** mehrere Fasern (1) parallel nebeneinander angeordnet sind, so daß eine Monolage von Fasern gebildet wird.

8. Elektromechanischer Wandler nach Anspruch 7,
**dadurch gekennzeichnet,**
**daß** mehrere Monolagen der Fasern (1) übereinander liegen.

9. Elektromechanischer Wandler nach Anspruch 7 oder 8,
**dadurch gekennzeichnet,**
**daß** sich oberhalb und/oder unterhalb der Monolage(n) weitere Schichten (5) aus anderen Materialien anschließen.

10. Elektromechanischer Wandler nach einem der Ansprüche 1 bis 9,
**dadurch gekennzeichnet,**
**daß** die Fasern (1) in eine Polymerschicht eingebettet sind.

11. Elektromechanischer Wandler nach einem der Ansprüche 1 bis 10,
**dadurch gekennzeichnet,**
**daß** das piezoelektrische Material eine ferroelektrische Keramik ist.

12. Verbundwerkstoff aus mehreren Schichten,
**dadurch gekennzeichnet,**
**daß** zumindest eine der Schichten den elektromechanischen Wandler nach einem der Ansprüche 1 bis 11 aufweist.

13. Verfahren zur Herstellung eines elektromechanischen Wandlers mit folgenden Schritten:
- Bereitstellen einer oder mehrerer langgestreckter Fasern (1) aus einem piezoelektrischen Material;
- Aufbringen der Faser(n) (1) auf eine Trägerschicht (3); und
- Aufbringen von elektrisch leitfähigem Material zur Bildung von Elektroden (2) an zumindest zwei voneinander beabstandeten Stellen direkt auf die Faser(n), so daß das leitfähige Material mit der/den Faser(n) in direktem Kontakt steht, die Faser(n) zumindest teilweise umschließt, und eine haftende Verbindung zwischen Faser(n) und dem leitfähigen Material hergestellt wird.

14. Verfahren zur Herstellung eines elektromechanischen Wandlers mit folgenden Schritten:
- Bereitstellen einer oder mehrerer langgestreckter Fasern (1) aus einem piezoelektrischen Material;
- Aufbringen von elektrisch leitfähigem Material zur Bildung von Elektroden (2) an zumindest zwei voneinander beabstandeten Stellen auf eine Trägerschicht (3);
- Aufbringen der Faser(n) (1) direkt auf das leitfähige Material, so daß das leitfähige Material mit der/den Faser(n) in direktem Kontakt steht, die Faser(n) zumindest teilweise umschließt, und eine haftende Verbindung zwischen Faser(n) und dem leitfähigen Material hergestellt wird.

15. Verfahren nach Anspruch 14,
**dadurch gekennzeichnet,**
**daß** weiterhin leitfähiges Material an Stellen direkt auf die Faser(n) aufgebracht wird, an denen die Faser bzw. Fasern von leitfähigem Material bereits teilweise umschlossen ist bzw. sind, so daß das leitfähige Material die Faser(n) vollständig umschließt.

16. Verfahren nach Anspruch 14 oder 15,
**dadurch gekennzeichnet,**
**daß** vor dem Aufbringen des leitfähigen Materials eine Negativform zur Vorgabe einer Interdigitalgeometrie der Elektroden auf die Trägerschicht aufgebracht wird, wobei das leitfähige Material in die Negativform eingebracht wird.

17. Verfahren nach einem der Ansprüche 13 bis 16,
**dadurch gekennzeichnet,**
**daß** das leitfähige Material ein elektrisch leitfähiger Klebstoff, insbesondere ein thixotropes Polymer ist.

18. Verfahren nach einem der Ansprüche 13 bis 17,
**dadurch gekennzeichnet,**
**daß** die Trägerschicht (3) mit noch nassem leitfähigen Klebstoff auf die Fasern abgesenkt wird, wobei die Fasern in den Klebstoff gedrückt werden.

19. Verfahren nach einem der Ansprüche 13 bis 17,
**dadurch gekennzeichnet,**
**daß** die Trägerschicht (3) Teil eines Verbundwerkstoffes ist, in den der elektromechanische Wandler integriert werden soll.

## Claims

1. An electromechanical transducer with at least one elongated fibre (1) of a piezoelectric material and at least two electrodes (2) which are provided at mutually spaced places on the fibre, in order to impose an electric field in the longitudinal direction on the fibre, **characterized in that** the electrodes (1) are in direct contact with the fibre (1), the individual electrodes at least partially surrounding the fibre.

2. An electromechanical transducer according to claim 1, **characterized in that** the electrodes (2) are formed from an electrically conductive adhesive.

3. An electromechanical transducer according to claim 1 or 2, **characterized in that** the individual electrodes (2) completely surround the fibre (1).

4. An electromechanical transducer according to any of claims 1 to 3, **characterized in that** the fibre (1) has a diameter of less than 100 µm.

5. An electromechanical transducer according to any of claims 1 to 4, **characterized in that** the fibre (1) has a length from 5 to 100 mm.

6. An electromechanical transducer according to any of claims 1 to 5, **characterized in that** a plurality of electrodes (2) are arranged along the longitudinal axis of the fibre (1) in an interdigitatated geometry.

7. An electromechanical transducer according to any of claims 1 to 6, **characterized in that** a plurality of fibres (1) are arranged parallel alongside one another, so that a mono-layer of fibres is formed.

8. An electromechanical transducer according to claim 7, **characterized in that** a plurality of mono-layers of the fibres (1) lie one on the other.

9. An electromechanical transducer according to claim 7 or 8, **characterized in that** further layers (5) of other materials are attached to the mono-layer(s), on top and/or underneath.

10. An electromechanical transducer according to any of claims 1 to 9, **characterized in that** the fibres (1) are embedded in a polymer layer.

11. An electromechanical transducer according to any of claims 1 to 10, **characterized in that** the piezoelectric material is a ferroelectric ceramic.

12. A composite material of a plurality of layers, **characterized in that** at least one of the layers comprises the electromechanical transducer according to any of claims 1 to 11.

13. A method of making an electromechanical transducer with the following steps:
- providing one or more elongated fibres (1) of a piezoelectric material;
- applying the fibre(s) (1) to a supporting layer (3); and
- applying electrically conductive material for forming electrodes (2) at at least two places spaced from one another, directly on the fibre(s), so that the conductive material is in direct contact with the fibre(s), at least partially surrounds the fibre(s), and an adhesive connection between the fibre(s) and the conductive material is created.

14. A method of producing an electromechanical transducer with the following steps:
- providing one or more elongated fibres (1) of a piezoelectric material;
- applying electrically conductive material for forming electrodes (2) at at least two places spaced from one another on a supporting layer (3),
- applying the fibre(s) (1) directly on the conductive material, so that the conductive material is in direct contact with the fibre(s), at least partially surrounds the fibre(s), and an adhesive connection between the fibre(s) and the conductive material is created.

15. A method according to claim 14, **characterized in that** conductive material is further applied directly on the fibre(s) at places whereat which the fibre or fibres is or are already partially enclosed by conductive material, so that the conductive material completely surrounds the fibre(s).

16. A method according to claim 14 or 15, **characterized in that** a negative pattern for definition of an interdigitated geometry of the electrodes is applied on the supporting layer before the application of the conductive material, whereby the conductive material is applied in the negative pattern.

17. A method according to any of claims 13 to 16, **characterized in that** the conductive material is an electrically conductive adhesive, especially a thixotropic polymer.

18. A method according to any of claims 13 to 17, **characterized in that** the supporting layer (3) is put down on the fibres with still wet conductive adhesive, whereby the fibres are pressed into the adhesive.

19. A method according to any of claims 13 to 17, **characterized in that** the supporting layer (3) is part of a composite material in which the electromechanical transducer is to be integrated.

## Revendications

1. Convertisseur électromécanique comportant au moins une fibre (1), allongée, en une matière piézo-électrique et au moins deux électrodes (2) prévues à des endroits distants l'un de l'autre de la fibre pour appliquer un champ électrique à la fibre dans la direction longitudinale,
**caractérisé en ce que**
les électrodes (2) sont en contact direct avec la fibre (1), les différentes électrodes entourant au moins en partie la fibre.

2. Convertisseur électromécanique selon la revendication 1,
**caractérisé en ce que**
les électrodes (2) sont réalisées en une colle électroconductrice.

3. Convertisseur électromécanique selon la revendication 1 ou 2,
**caractérisé en ce que**
les différentes électrodes (2) entourent complètement la fibre (1).

4. Convertisseur électromécanique selon l'une des revendications 1 à 3,
**caractérisé en ce que**
la fibre (1) a un diamètre d'au moins 100 µm.

5. Convertisseur électromécanique selon l'une des revendications 1 à 4,
**caractérisé en ce que**
la fibre (1) a une longueur de 5 à 100 mm.

6. Convertisseur électromécanique selon l'une des revendications 1 à 5,
**caractérisé en ce que**
le long de l'axe longitudinal de la fibre (1) plusieurs électrodes (2) sont réparties suivant une disposition géométrique interdigitée.

7. Convertisseur électromécanique selon l'une des revendications 1 à 6,
**caractérisé en ce que**
plusieurs fibres (1) sont disposées parallèlement les unes aux autres pour former une monocouche de fibres.

8. Convertisseur électromécanique selon la revendication 7,
**caractérisé en ce que**
plusieurs monocouches de fibres (1) sont superposées.

9. Convertisseur électromécanique selon l'une des revendications 7 ou 8,
**caractérisé en ce que**
d'autres couches (5) en d'autres matériaux sont prévues au-dessus et/ou en dessous de la ou des monocouches.

10. Convertisseur électromécanique selon l'une des revendications 1 à 9,
**caractérisé en ce que**
les fibres sont intégrées dans une couche de polymère.

11. Convertisseur électromécanique selon l'une des revendications 1 à 10,
**caractérisé en ce que**
la matière piézo-électrique est une céramique ferroélectrique.

12. Matériau composite formé de plusieurs couches,
**caractérisé en ce qu'**
au moins l'une des couches comporte un convertisseur électromécanique selon l'une des revendications 1 à 11.

13. Procédé de réalisation d'un convertisseur électromécanique comprenant les étapes suivantes :
- on réalise une ou plusieurs fibres allongées (1) en une matière piézo-électrique,
- on applique les fibres (1) sur une couche de support (3) et
- on applique une matière conductrice électrique pour former des électrodes (2) en au moins deux points distants l'un de l'autre, directement sur la ou les fibres pour que la matière conductrice soit directement en contact avec la ou les fibres, entourant au moins partiellement la ou les fibres et réalisant une liaison par collage entre la ou les fibres et la matière conductrice.

14. Procédé de réalisation d'un convertisseur électromécanique comprenant les étapes suivantes :
- on réalise une ou plusieurs fibres allongées (1) en une matière piézo-électrique,
- on applique une matière électroconductrice pour former des électrodes (2) en au moins deux points écartés l'un de l'autre sur une couche de support (3),
- on applique la ou les fibres indirectement sur la matière conductrice de façon que celle-ci soit en contact direct avec la ou les fibres, en entourant au moins partiellement la ou les fibres et en réalisant une liaison par collage entre la ou les fibres et la matière conductrice.

15. Procédé selon la revendication 14,
**caractérisé en ce qu'**
on applique en outre une matière conductrice directement sur la ou les fibres, à des endroits où ces fibres sont déjà entourées partiellement de matière conductrice de façon que la matière conductrice entoure complètement la ou les fibres.

16. Procédé selon la revendication 14 ou 15,
**caractérisé en ce qu'**
avant d'appliquer la matière conductrice on prévoit un moule négatif pour prédéfinir la géométrie de la répartition interdigitée des électrodes sur la couche de support, la matière conductrice étant placée dans le moule négatif.

17. Procédé selon l'une des revendications 13 à 16,
**caractérisé en ce que**
la matière conductrice est une colle électroconductrice, en particulier un polymère thixotrope.

18. Procédé selon l'une des revendications 13 à 17,
**caractérisé en ce qu'**
on abaisse la couche de support (3) avec de la colle électroconductrice, encore humide, sur les fibres pour que les fibres s'enfoncent dans la colle.

19. Procédé selon l'une des revendications 13 à 17,
**caractérisé en ce que**
la couche de support (3) fait partie d'un matériau composite dans lequel on veut intégrer le convertisseur électromécanique.
